Europäisches Patentamt

European Patent Office

Office européen des brevets

(19)

(11) **EP 0 491 152 B1**

(12) **EUROPEAN PATENT SPECIFICATION**

(45) Date of publication and mention
of the grant of the patent:
**21.02.1996  Bulletin 1996/08**

(51) Int Cl.6: **H01S 3/19**, H01S 3/103,
H01S 3/25, H04B 10/12

(21) Application number: **91119097.3**

(22) Date of filing: **08.11.1991**

(54) **Semiconductor laser devices with a plurality of light emitting layers having different bands gaps and methods for driving the same**

Halbleiterlaser-Vorrichtungen mit mehreren lichtemittierenden Schichten deren Bandlücken verschieden sind und Verfahren zu ihrer Ansteuerung

Dispositifs laser à semi-conducteur avec plusieurs couches émettrices de lumière à bandes interdites différentes et méthodes pour les commander

(84) Designated Contracting States:
**DE FR GB NL**

(30) Priority: **11.11.1990  JP 304407/90**

(43) Date of publication of application:
**24.06.1992  Bulletin 1992/26**

(73) Proprietor: **CANON KABUSHIKI KAISHA
Tokyo (JP)**

(72) Inventors:
• **Ikeda, Sotomitsu,
c/o CANON KABUSHIKI KAISHA
Tokyo (JP)**
• **Nitta, Jun, c/o CANON KABUSHIKI KAISHA
Tokyo (JP)**

(74) Representative: **Kinne, Reinhard, Dipl.-Ing.
D-80336 München (DE)**

(56) References cited:
**EP-A- 0 390 167          EP-A- 0 390 200**

• **JAPANESE JOURNAL OF APPLIED PHYSICS
(1989) 28-30 AUGUST , 21RST CONFERENCE,
Tokyo,JA;pages 317 - 320; SOTOMITSU IKEDA
et al.: "Wavelength switching of asymmetric
dual quantum well lasers"**
• **APPLIED PHYSICS LETTERS. vol. 55, no. 12, 18
September 1989, NEW YORK US pages 1155 -
1157; SOTOMITSU IKEDA ET AL.: 'Asymmetric
dual quamtum well laser - wavelength
switching controlled by injection current'**
• **APPLIED PHYSICS LETTERS. vol. 55, no. 20, 13
November 1989, NEW YORK US pages 2057 -
2059; SOTOMITSU IKEDA ET AL.: 'Wide-range
wavelength tuning of an asymmetric dual
quantum well laser with inhomogeneous
current injection'**
• **APPLIED PHYSICS LETTERS. vol. 59, no. 7, 12
August 1991, NEW YORK US pages 765 - 767;
AKIRA SHIMIZU ET AL.: 'Theory of asymmetric
dual quantum well lasers'**

## Description

BACKGROUND OF THE INVENTION

Field of the Invention

This invention relates to semiconductor laser devices with a plurali-ty of light emitting layers having different band gaps and methods for driving the same which are to be utilized in wavelength or frequency division multiplexing optical communication systems, wavelength division multiplexing optical recording systems, optical operation systems and the like and, more particularly, to semiconductor laser devices for emitting laser lights of different wavelengths by controlling the magnitude of a current injected thereinto and driving methods therefor.

Related Background Art

In recent years, demands for semiconductor laser devices have rapidly been increasing in fields of optical communications and optical information processings, and accompanied therewith requirements for functions of devices to be used in such fields have become diverse. Among them, there exist tunable (wavelength of a radiated light is changeable) semiconductor laser devices. For example, in a case where a laser light is applied to a record medium such as an optical card and an optical disc for performing information recording and reproduction, information writing by a reproducing light is normally prevented by reducing the magnitude of the reproducing light to a value less than that of a recording light for recording information on the record medium. In this case, if a tunable semiconductor laser is used and a wavelength of its reproducing light is set to be within a range in which a light sensitivity of a medium is low, the prevention of information writing by the reproducing light is effected without reducing the magnitude thereof so much. Thus, the reproduction of information can be performed with a high S/N ratio by the reproducing light having a sufficient magnitude.

In order to satisfy the above-mentioned requirement, there has been developed a first prior art tunable laser device in which light emitting layers for selectively emitting lights of different wavelengths are respectively formed in different light waveguides formed on a common substrate and a laser oscillation is conducted in the light emitting layer of a desired oscillation wavelength by a current injection thereinto (see Appl. Phys. Lett. vol. 36, p. 442(1980)). In this case, it can be said that essentially separate or independent laser devices are formed on a common substrate.

The first prior art device, however, has the following disadvantages.

When the emission or oscillation wavelength is changed, the location of light emission from the device is varied. As a result, for example, where an external optical system for condensing a radiated light from the laser device is structured so that the light of a certain wavelength is condensed into a point, a focused position will be shifted far greater than a small shift due to a wavelength dispersion caused when the emission wavelength is changed. Further, since there is a need to form separate, independent laser devices on a common substrate and to drive them separately, a fabrication process will be complicated and a size of the device will be large.

Next, there has been developed a second prior art tunable laser device which is a distributed Bragg reflector (DBR) type semiconductor laser using a grating as a reflector. In the device, an electrode is further provided in the grating portion for injecting carriers therethrough, and an amount of injection current thereinto is increased or reduced so that the oscillation wavelength is changed by varying a refractive index of the grating portion. In this case, structures of light emitting layers, etc., are the same as those of a normal semiconductor laser.

The second prior art device, however, has a drawback as follows. A range of variable wavelength is narrow, and in a case where, for example, $Al_xGa_{1-x}As$ is used, such range is several nanometers. This is because the change of Bragg wavelength by the control of an amount of current injection which has such length of range decides the width or range of variable wavelength.

There has further been developed a third prior art tunable laser device in which a single quantum well layer constitutes of a light emitting layer and a light emission from a quantum energy level higher than a first or ground one is made possible by increasing loss of its resonator. Laser oscillations of different wavelengths are obtained from light emissions from the first and second quantum levels.

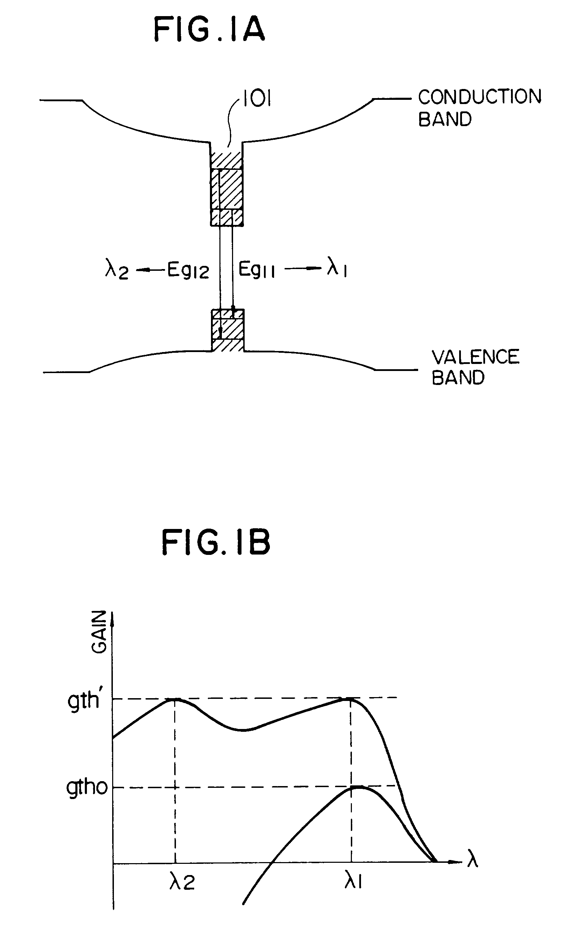

Fig. 1A shows an energy band of such single quantum well layer 101 and layers adjacent thereto. Fig. 1B shows its gain spectrum. In a laser having a conventional normal resonator loss, an oscillation threshold gain is $g_{tho}$, and its gain spectrum has a peak at a wavelength $\lambda_1$ corresponding to an energy gap $E_{g11}$ for the first quantum energy level at which the laser oscillation is performed. In the third prior art device, its resonator loss is increased, and its oscillation threshold gain is $g_{tho}$. Thus, the laser oscillation of a wavelength $\lambda_2$ corresponding to an energy gap $E_{g12}$ for the second quantum level is made possible.

In the third prior art device, however, the laser efficiency becomes small because the resonator loss is increased for achieving its object. As a result. the oscillation threshold current should be made large and its output cannot be made large. Therefore, a continuous emission at room temperature could not be obtained in such device which is to be act as a two-wavelength tunable laser.

Moreover, there has been disclosed a fourth prior art device in Japanese patent pre-examined publication No. 63-32982. In the fourth prior art device, there are provided two different quantum well layers respectively functioning as light emitting layers for emitting lights of slightly different wavelengths and laser oscillations of different wavelengths are achieved by the respective quantum well layers.

The fourth prior art device, however, also has the drawback that two oscillation wavelengths are quite close to each other or that its range of variable wavelength is narrow.

Additionally, from document EP-A-0 390 167 a semiconductor laser device is known wherein light emitting layers are arranged in an asymmetrical manner in order to make the emission of light of different wavelengths possible. Furthermore, carrier confinement layers are provided on the respective light emitting layers to provide good recombination efficiency, the band gaps of the confinement layers being symmetrical to each other when taking the respective edges of the light emitting layers as reference lines. Moreover, a barrier layer is disposed between the light emitting layers and confinement layers are arranged in the respective other sides of the light emitting layers.

## SUMMARY OF THE INVENTION

An object of the present invention is to provide a tunable semiconductor laser device which has a wide range of variable oscillation wavelength and operates with a high efficiency and a method for driving such a semiconductor laser device.

According to one aspect of the present invention as claimed in Claim 1, this object is accomplished by a semiconductor laser device, comprising: a plurality of light emitting quantum well layers having band gaps of ground energy levels being different from each other; a barrier layer formed between said light emitting quantum well layers, said barrier layer having a band gap being larger than those of said light emitting quantum well layers; and a pair of light-electron confinement layers for sandwiching said light emitting quantum well layers and said barrier layer; wherein said light emitting quantum well layers, said barrier layer and said light-electron confinement layers are formed such that, when carriers are injected into said light emitting quantum well layers, a carrier density of said light emitting quantum well layer having a larger band gap is made higher and a carrier density of said light emitting quantum well layer having a smaller band gap is made lower than those which would be obtained when said barrier layer is omitted, and wherein said pair of light-electron confinement layers are asymmetrically formed with respect to said light emitting quantum well layers, said semiconductor laser device being characterized in that said light-electron confinement layers have band gaps being different from each other at the interface where each of said light-electron confinement layers is adjacent to the corresponding light emitting quantum well layer, with the light-electron confinement layer having the smaller band gap being disposed adjacent to the light emitting quantum well layer having the larger band gap.

According to one aspect of a method, as claimed in Claim 12, for driving the above-mentioned laser device of the present invention, a method includes the steps of: injecting a current in a forward direction into said semiconductor laser device; controlling an amount of said current; and performing a laser oscillation of light having a wavelength corresponding to any desired one of the band gaps of said light emitting quantum well layers.

According to another aspect of a method, as claimed in Claim 13, for driving the above-mentioned laser device of the present invention, a method includes the steps of: injecting a current, having an amount slightly smaller than that of a threshold current for performing a laser oscillation, into said semiconductor laser device; causing an incident light having a wavelength close to that of a laser oscillation light to enter said semiconductor laser device through its one end surface; and taking out a light having the same wavelength as that of the incident light through the other end surface of said semiconductor laser device.

According to still another aspect of a method, as claimed in Claim 14, for driving the above-mentioned laser device, a method includes the steps of: injecting a current, having an amount slightly smaller than that of a threshold current for performing a laser oscillation, into said semiconductor laser device; causing an incident light having a photon energy larger than a band gap of its light emitting quantum well layer to enter said semiconductor laser device through its one end surface; and taking out a light having a wavelength different from that of the incident light through the other end surface of said semiconductor laser device.

Furthermore, according to one aspect of an optical communication system, as claimed in Claim 15 and including the above-mentioned laser device, an optical communication system is characterized in that said system comprises a plurality of terminals, each of said terminals including a light transmitter including a semiconductor laser device and a light receiver, and an optical fiber for connecting said plurality of terminals with each other.

The band gap in this specification means a transition energy from a certain energy level in the valence band to a certain energy level in the conduction band including a quantum energy in a case of a quantum well structure.

According to the present invention, disadvantages mentioned above have been solved.

As for the disadvantages of the first prior art device, in the laser device of this invention, light emitting layers for different oscillation wavelengths are formed in a single light waveguide, so that a light emission position will not be changed even if the oscillation wavelength is changed. Further, there is no need to provide separate and independent current injection means for respective oscillation wavelengths, so that its fabricatinn is easy and a size of the device is about equal to that of conventional semiconductor lasers.

As for the disadvantages of the second prior art device, in the laser device of this invention, respective wavelength oscillations are performed by separate light emitting layers formed on a single light waveguide, so that a changeable oscillation can be conducted in a wider range of wavelength. For example. when $Al_xGa_{1-x}As$ is used to form the light emitting layers, oscillation wavelengths can be changed in a range having a width from several tens μm to several hundreds nm.

As for the disadvantages of the third prior art device, in the laser device of this invention, since there is provided a barrier layer having a larger band gap than those of adjacent light emitting layers and formed between these light emitting layers and the band gap and thickness of the barrier layer, for example, are set such that, when carriers are injected into the light emitting layers, a carrier density of the light emitting layer having a larger band gap is made higher and a carrier density of the light emitting layer having a smaller band gap is made lower than a case where the barrier layer is omitted, the gain distribution extends toward a short wavelength compared with the prior art device when the same amount of carriers are injected into the device. As a result, lights of plural wavelengths can be oscillated even unless the resonator loss is increased and a large amount of current is injected.

Further, the barrier layer (or light emitting layer in addition thereto) is preferably doped with p or n type dopants in order to further increase efficiency of the laser device of this invention. Especially, it is preferable to perform the doping of a polarity opposite to that of carriers (electrons or holes) which are to be unevenly injected. This is because carriers to be evenly injected can be supplemented by the doping beforehand.

Due to the above-discussed structure, the efficiency of laser becomes extremely higher than the conventional laser devices, and a tunable laser which has an oscillation threshold current value equal to or twice less than a value of conventional semiconductor lasers (not tunable) can be achieved. Especially, a continuous oscillation at room temperature can be achieved, which could not be obtained in conventional tunable devices having a wide range of oscillation wavelength.

As for the disadvantages of the fourth prior art device, in the laser device of this invention, since there can be provided light emitting layers having greatly different wavelengths and the device is structured in a manner mentioned above, these advantages can be solved. It should be noted that a light having a short wavelength cannot be oscillated unless a large amount of current is injected only by simply making the wavelength difference of the light emitting layers large. Therefore, the same problems as those of the third prior art device remain. According to this invention, not only such wavelength difference is made large, but also a flow of carriers is skillfully controlled by the height and thickness of the barrier layer, the doping and so forth, so that a highly efficient tunable laser having a great difference of oscillation wavelength can be realized.

These advantages and others will be more readily understood in connection with the following detailed description, claims and drawing.

## BRIEF DESCRIPTION OF THE DRAWINGS

Fig. 1A is a representation of a band structure of a light waveguide portion in a prior art semiconductor laser device having a single quantum well layer as an active layer.

Fig. 1B is a representation of a gain spectrum of the device of Fig. 1A.

Fig. 2 is a schematic perspective view of the first embodiment.

Fig. 2A is a representation of a band structure of a light waveguide portion in a first embodiment of a semiconductor laser device according to the present invention.

Figs. 2B-2D are respectively representations of gain spectra of the device of Fig. 2A.

Fig. 3A is a side cross-sectional view showing a first embodiment of a ridge waveguide type semiconductor laser device.

Fig. 3B is a front cross-sectional view showing the first embodiment.

Fig. 4 is a representation of a band structure of a light waveguide portion in a second embodiment of a semiconductor laser device according to the present invention.

Fig. 5 is a representation of a band structure of a light waveguide portion in a third embodiment of a semiconductor laser device according to the present invention.

Fig. 6 is a representation of a band structure of a light waveguide portion in a fourth embodiment of a semiconductor laser device according to the present invention.

Fig. 7 is a block diagram showing an example in which the device of this invention is used as a laser diode.

## DESCRIPTION OF THE PREFERRED EMBODIMENT

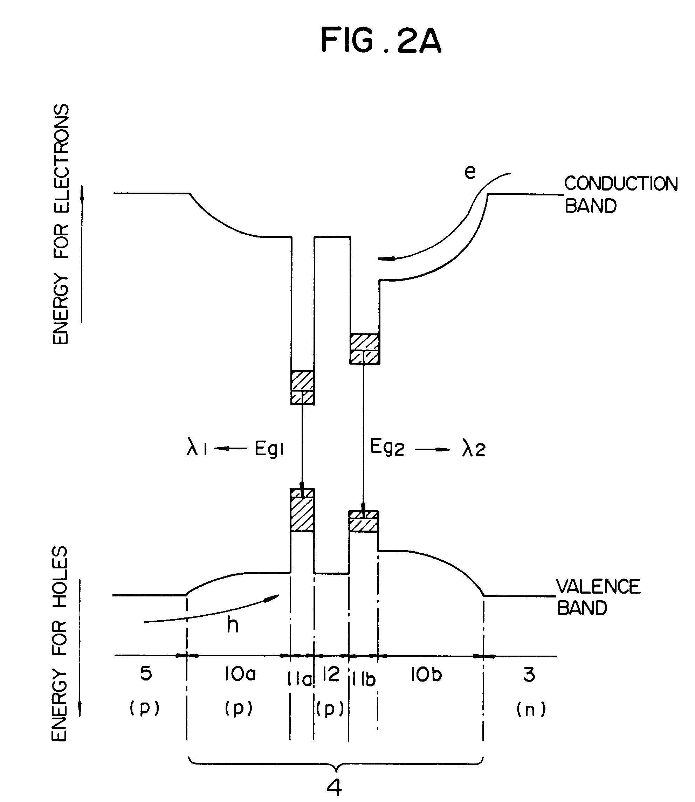

Embodiments will be explained referring to Figs. 2A-6 in the following. In the following embodiments, emission wavelengths are two and hence two light emitting layers are provided. The number thereof may naturally be more than two. The principle is the same in all these cases.

Fig. 2A illustrates the energy band structure of an active layer 11a and 11b and layers adjacent thereto of a first embodiment of the semiconductor laser. In Fig. 2A, there are depicted energy levels of $p\text{-}Al_{xs}Ga_{1-xs}As$ light-electron separate confinement layer (SC layer) 10a, $n\text{-}Al_{xs}'Ga_{1-xs}'As$ SC layer 10b, $Al_{xa}Ga_{1-xa}As$ light emitting layer 11a, $Al_{xb}Ga_{1-xb}As$ light emitting layer 11b, $p^+\text{-}Al_{xB}Ga_{1-xB}As$ barrier layer 12. These layers constitute a light waveguide structure portion 4.

In the first embodiment, the light emitting layer 11b for short wavelength emission ($\lambda_2$) is provided at the side of an n-cladding layer 3 and the light emitting layer 11a for long wavelength emission ($\lambda_1$) is provided at the side of a p-cladding layer 5, so that it is difficult for holes injected from the side of the p-cladding layer 5 to reach the light emitting layer 11b for short wavelength $\lambda_2$ compared with a case where holes move in a reverse direction. Therefore, the barrier layer 12 is doped with a high concentration of p-type dopants and thus holes are supplied beforehand. Here, the short wavelength $\lambda_2$ corresponds to an energy gap $E_{g2}$ between energy levels in conduction and valence bands of the light emitting layer 11b, and the long wavelength $\lambda_1$ corresponds to an energy gap $E_{g1}$ between energy levels in conduction and valence bands of the light emitting layer 11a.

Since holes are supplied sufficiently, holes are properly distributed over the light emitting layers 11a and 11b when no current is injected into the device. In this case, the distribution of electrons has only to be considered for discussing the laser oscillation. The operation of such case will be explained. A case where p and n are exchanged with each other will also be discussed below.

The SC layers 10a and 10b function to effectively capture injected electrons and injected holes into the active layers 11a and 11b and increase the recombination efficiency of carriers.

In the first embodiment, the SC layers 10a and 10b sandwiching the active layers 11a and 11b (quantum well layers) are asymmetrically formed, so that an injected carrier density in the quantum well layer 11b closer to the SC layer 10b having a smaller band gap is enhanced compared with that in the quantum well layer 11a closer to the SC layer 10a having a larger band gap. As a result, the gain of the quantum well layer 11b at the side of the SC layer 10b having a smaller band gap is increased.

In a conventional semiconductor laser, injected carriers are distributed over light emitting layers of an active layer structure in a thermal equilibrium state, so that the gain of the light emitting layer having a smaller energy gap becomes extremely large but that the gain of the other light emitting layer having a larger energy gap cannot become large enough.

Therefore, in the first embodiment, parts of the barrier layer 12 and the SC layer 10a are doped with p type dopants to supply sufficient holes to the light emitting layers 11a and 11b. On the other hand, electrons are injected from the n cladding layer 3 and fall into the light emitting layer 11b through the SC layer 10b having a smaller band gap. At this time, since the band gap of the barrier layer 12 is large, most of the electrons cannot travel over the barrier layer 12. Thus, the electron density of the light emitting layer 11b is further increased.

At this time, the thickness of the light emitting layer 11a having a smaller band gap is set to less than a scattering length of carrier (for example, less than about 10nm (100 Å) since energy is lowered by 37 meV in a case of longitudinal optical (L0) phonon scattering). Hence, only a small amount of the injected carriers are captured in the light emitting layer 11a and a large amount of carriers are captured in the light emitting layer 11b.

Further, the thickness and potential hight (depth) of the barrier layer 12 are set to sufficient magnitudes, so that the carrier distribution in the light emitting layers or well layers 11a and 11b is as shown in Fig. 2A when a current close to the laser oscillation threshold value is injected. Namely, the carrier density of the light emitting layer 11b having a larger band gap is made relatively high.

If the barrier layer 12 is too thin or too low, the carrier distribution becomes uniform or even similar to a case where there is provided no barrier layer. But in the case of Fig. 2A the barrier layer 12 is set such that a larger amount of electrons are supplied to the well layer 11b for short wavelength $\lambda_2$. However, if the barrier layer 12 is too thick and/or too high, electrons could not reach the well layer 11a. Therefore, factors of the barrier layer 12 should be optimized.

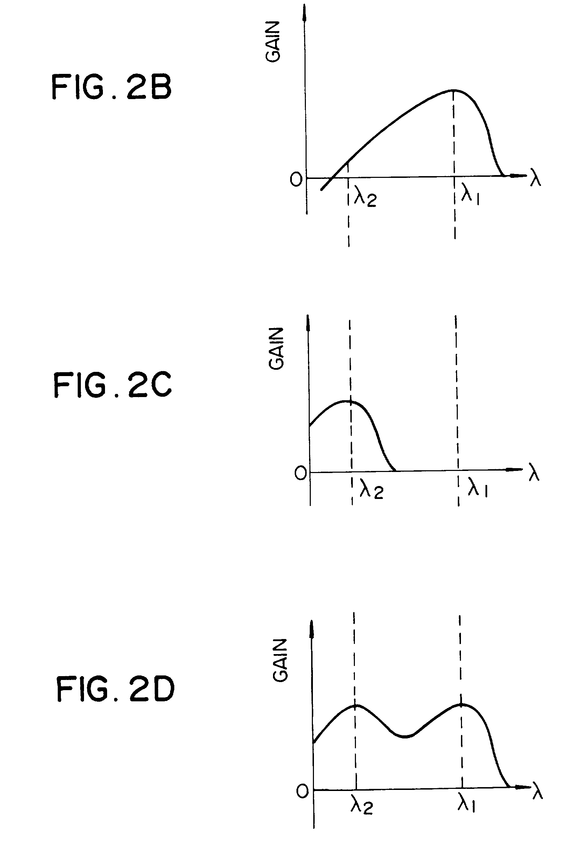

Figs. 2B and 2C respectively show the gain spectra of the well layers 11a and 11b wherein a current slightly smaller than a threshold current is injected, and Fig. 2D shows the gain spectrum resulting from the sum of these spectra considering a light confinement coefficient.

As seen from Fig. 2D, gains for respective wavelengths $\lambda_1$ and $\lambda_2$ are decided by gains of the respective well layers 11a and 11b for those wavelengths shown in Figs 2B and 2C. Hence, the gains for the wavelengths $\lambda_1$ and $\lambda_2$ can effectively be increased.

In the first embodiment, the SC layers 10a and 10b respectively employ graded index (GRIN) structures. The GRIN structure may be replaced with a step index type in which the energy gap or refractive index varies in a stepped form, a structure in which the energy gap is changed linearly, or the like. A necessary thing is to form the SC layers 10a and 10b having an asymmetric band gap with respect to plural light emitting layers 11a and 11b therebetween.

In the first embodiment, the band gap of the barrier layer 12 is set equal to the band gap of a portion of the SC layer 10a adjacent to the light emitting layer 11a. But, the band gap of the barrier layer 12 has only to be set larger than that of a portion of the SC layer 10b adjacent to the light emitting layer 11b and smaller than those of the cladding layers 3 and 5.

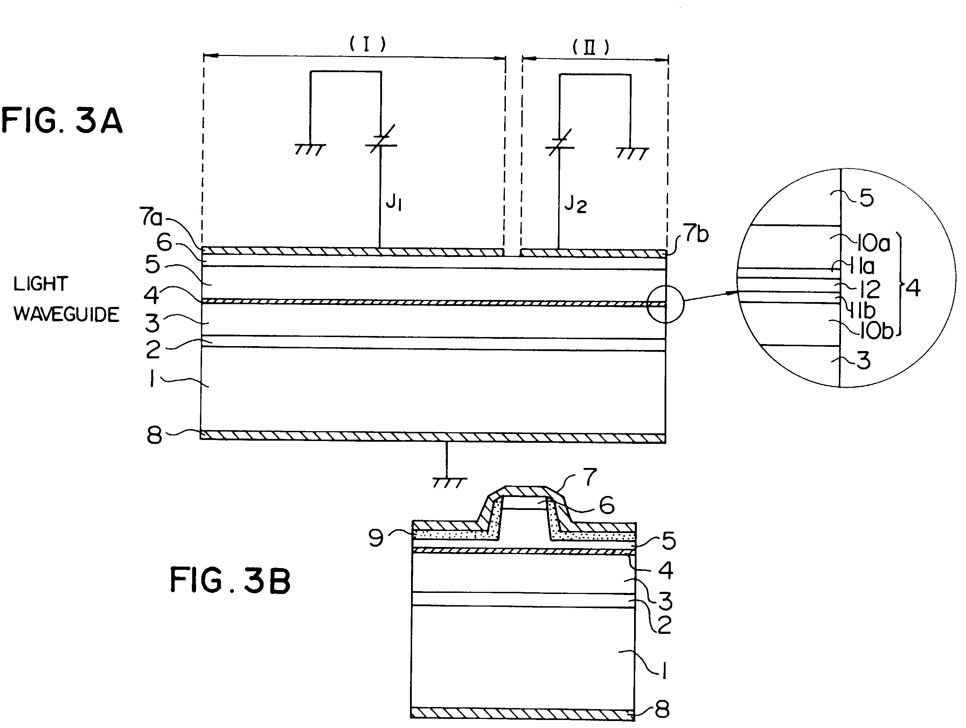

Fig. 3A shows a side cross-sectional view of a concrete layered structure of the first embodiment of the semiconductor laser device, and Fig. 3B shows a front cross-sectional view thereof. Such structure can be formed using molecular beam epitaxy (MBE) method, metal organic-chemical vapor deposition (MOCVD) method or the like. Such process is the same as that used in a case where conventional semiconductor lasers are formed.

In Figs. 3A and 3B, there are provided on an

$n^+$-GaAs substrate 1 an $n^+$-GaAs buffer layer 2, n-$Al_{xc}Ga_{1-xc}$AS cladding layer 3, the above-discussed light waveguide structure portion 4, p-$Al_{xc}Ga_{1-xc}$As cladding layer 5, $p^+$-GaAs cap layer 6, Au/Cr electrode 7 and Au-Ge/Au electrode 8.

As shown in Fig. 3B, a ridge (raised channel) type waveguide is formed by reactive ion beam etching (RIBE) method or the like in order to confine electrons and light in a stripe-shaped region with respect to a lateral or horizontal direction. After an $Si_3N_4$ layer 9 is deposited by plasma CVD method, only the layer 9 on the ridge top is removed by etching and then the electrode 7 is deposited.

As a means for regulating an emission wavelength, the electrode 7 is divided into two parts 7a and 7b as shown in Fig. 3A, and currents $J_1$ and $J_2$ are to be independently injected through the two parts 7a and 7b of the electrode 7 separately. Currents are respectively injected through the two electrodes 7a and 7b with different current densities $J_1$ and $J_2$. The wavelength dispersion of an effective gain of the entire laser is slightly changed by changing a ratio and magnitudes of the current densities $J_1$ and $J_2$. Thus, the oscillation wavelength is varied.

As a method for changing the oscillation wavelength, there are other methods than that mentioned above. For example, a single electrode is used and the wavelength is controlled by the magnitude of current flowing through the single electrode. In this case, it was confirmed that light of a longer wavelength $\lambda_1$ is first oscillated and then light of a shorter wavelength $\lambda_2$ is also oscillated as the injection current is increased. If the current is further increased, there are two cases. in the first case, the oscillation of light of a longer wavelength $\lambda_1$ ceases. In the second case, this longer wavelength light continues to be oscillated. To obtain the first case operation, the light emitting layers 11a and 11b and the barrier layer 12 are set such that the following relation is satisfied:

$$g_1 (\lambda_2, n_1, p_1) > 0$$

where $g_1$ is a gain for wavelength $\lambda_2$ when the injected electron density in the light emitting layer 11a is $n_1$ and its injected hole density is $p_1$ (see Fig. 2B). In this case, the gain ($>0$) for the wavelength $\lambda_2$ as shown in Fig. 2B contributes to the oscillation, and the gain for the wavelength $\lambda_1$ is reduced leading to cassation of the oscillation of light having a longer wavelength $\lambda_1$. To obtain the second case operation, the light emitting layers 11a and 11b and the barrier layer 12 are set such that the above-mentioned gain $g_1$ satisfies the relation:

$$g_1 (\lambda_2, n_1, p_1) \leqq 0.$$

Especially, in the first case, the switching of oscillation wavelength is perfectly performed and hence this kind of device can have a wide range of application fields.

In room temperature, the mobility of holes in GaAs is 400 $cm^2$/V·s and this value is small compared with a value of 8800 $cm^2$/V·s of the mobility of electrons. Considering this fact, it is easier to realize an uneven injection of holes than that of electrons. So, it may be said that it is preferable to exchange n and p with each other in the structure as shown in Fig. 2A.

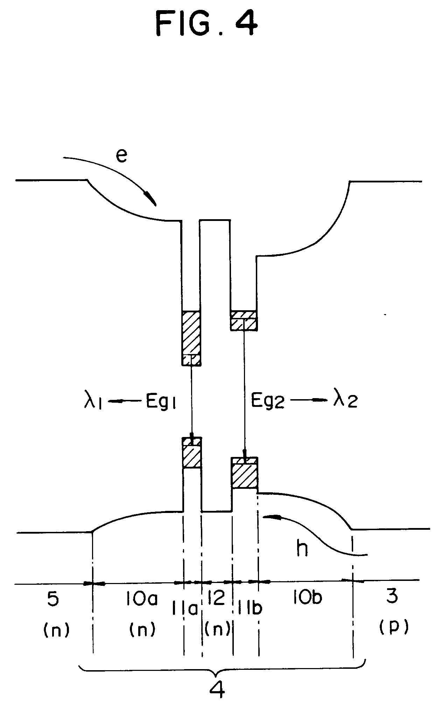

Fig. 4 shows this second embodiment. The operation and so forth thereof are substantially identical with those of the first embodiment of Fig. 2A with the exception that roles of holes and electrons are exchanged.

In the second embodiment, light emitting layers 11a and 11b are fulfilled with electrons, and the injection of holes is controlled. In this case, at least portions of the barrier layer 12 and/or SC layer 10a are doped with n type dopants, and the SC layer 10b having a smaller band gap is disposed at the side of the p-cladding layer 3 and the light emitting layer 11b having a larger band gap out of the two light emitting layers 11a and 11b is disposed near the p cladding layer 3.

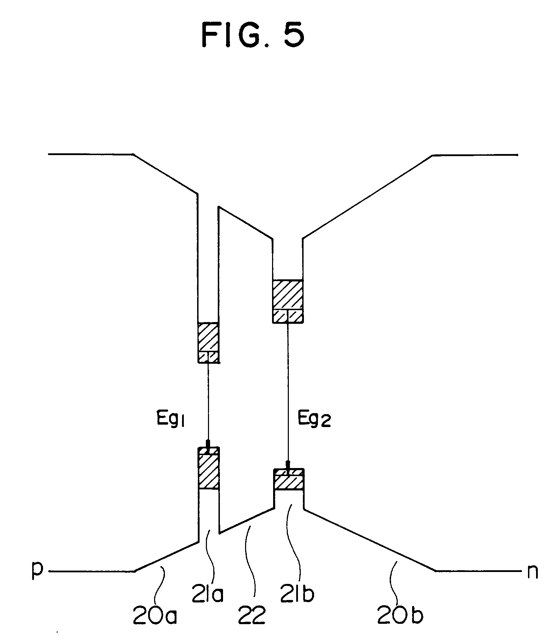

Fig. 5 shows the energy band profile of a third embodiment. In the third embodiment, a light emitting layer 21a having a smaller energy gap is formed as if the layer 21a were located in an SC layer 20a, and the composition of a barrier layer 22 is gradually changed in a direction of layer thickness. There are further provided the other light emitting layer 21b and the other SC layer 20b.

The operation principle thereof is substantially the same as that of the first embodiment if the height of the barrier layer 22, the thickness of the light emitting layer 21a and so forth satisfy the above-mentioned requirements. If a portion of the barrier layer 22 or SC layer 20a is doped with p type dopants, the light emitting layers 21a and 21b are fulfilled with holes and electrons can he injected unevenly. As a result, gains of the light emitting layers 21a and 21b can be increased only by a small amount of current density.

Also in the third embodiment, p and n can be exchanged as is explained in the second embodiment.

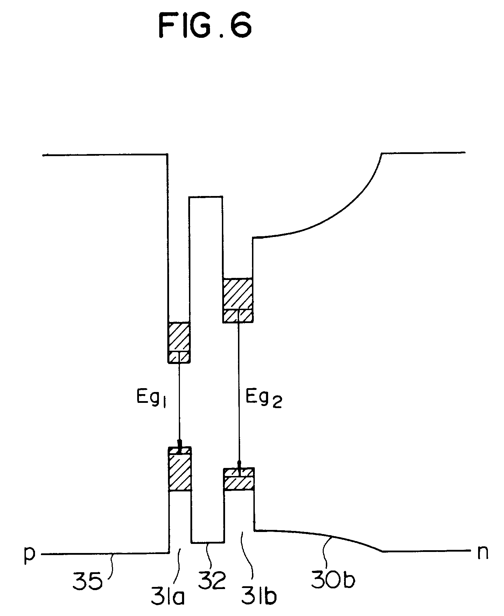

Fig. 6 shows the energy band structure of a fourth embodiment. In the fourth embodiment, one SC layer is made of the same composition as a cladding layer 35. In other words, the layer 35 functions as both cladding layer and SC layer. In the fourth embodiment, gains of the light emitting layers 31a and 31b can also be made large with a small amount of current density by fulfilling the light emitting layers 31a and 31b with holes and injecting electrons thereinto unevenly. There are futher provided an SC layer 30b and a barrier layer 32.

Also in the fourth embodiment, p and n can be exchanged. The operation principle thereof is substantially the same as that of the first embodiment.

In the above-discussed embodiments, $Al_xGa_{1-x}$As is used as semiconductor material, but any semiconductor material which can form a hetero-structure may be used. Further, as a structure for confining light and current, a ridge type waveguide is used, but any type of confining structure which is used in conventional semiconductor lasers may be used. Methods and fabrications therefor are explained in for example T. Tsukada,

"GaAs-Ga$_{1-x}$Al$_x$As buried-hetero structure injection Lasers", J. Appl. Phys., vol. 45, pp. 4899 (1974), T. Tsukada et al., Appl. Phys. Lett., vol. 20, pp. 344(1972) and K. Ito et al., "Fundamental transverse and longitudinal made oscillation in terraced substrate GaAs(GaAl)As Lasers", IEEE Journal of Quantum Electronics, vol. QE-15, no. 8, pp. 714 (1979).

The laser device according to the present invention may be used as a highly effective optical amplifier which operates in a wide range of wavelength. In this case, a current slightly smaller than a laser oscillation threshold current is injected into the semiconductor laser device of this invention and light having a wavelength close to a laser oscillation wavelength is entered from an external light source through one end surface of the device to take out a light having the same wavelength as that of the incident light.

The laser device of this invention has a gain over a wider wavelength range than that of conventional devices, so that the device can be used as an optical amplifier which has a high efficiency and operates in a wide range of wavelength.

The laser device according to the present invention may also be used as a highly effective optical wavelength converter which operates in a wide range of wavelength. In this case, a current slightly smaller than a laser oscillation threshold current is injected into the semiconductor laser device of this invention and a light having a photon energy larger than a band gap of its light emitting layer is entered from an external light source through one end surface of the device. Then, carriers are generated and a light having a wavelength different from that of the incident light radiated from a light emitting layer of the device is emitted from its end surface. This emission light has a wavelength of or close to a wavelength $\lambda_1$ if the current beforehand biased is close to a threshold current for light of the oscillation wavelength $\lambda_1$. If the current beforehand biased is close to a threshold current for light of the oscillation wavelength $\lambda_2$, the emission light has a wavelength of or close to a wavelength $\lambda_2$. When the device of this invention is used, a highly effective optical wavelength converter which operates in a wider range of wavelength than conventional devices and easily oscillates light of a short wavelength can be realized.

As has been explained above, in the laser device of this invention, light emitting layers for different oscillation wavelengths are formed in a single light waveguide, so that a light emission position will not be changed even if the oscillation wavelength is changed.

Further, there is no need to provide separate current injection means for respective oscillation wavelengths, so that its fabrication is easy and a size of the device is about equal to conventional semiconductor lasers.

Further, since respective wavelength oscillations are performed by separate light emitting layers formed on a single light waveguide, the oscillation can be performed in a wider range of wavelength.

Further, lights of plural wavelength can selectively or simultaneously be oscillated without injecting a large amount of current with an increased resonator loss. This is attained by properly setting the band gap and thickness of a barrier layer. As a result, the efficiency of laser becomes extremely higher than the conventional laser devices, and a tunable laser which has an oscillation threshold current value twice less than that of conventional semiconductor lasers (not tunable) can be achieved. Especially, a continuous oscillation at room temperature can be achieved, which could not be obtained in conventional tunable devices having a wide range of oscillation wavelength.

When the laser device of this invention is utilized as an optical amplifier and an optical wavelength converter, such optical amplifier and optical wavelength converter have a high efficiency and operate in a wider range of wavelength than the conventional devices.

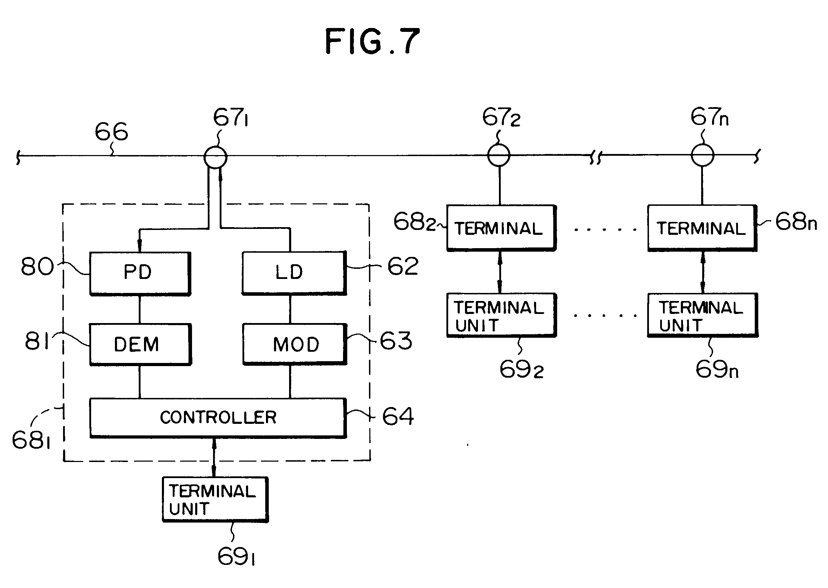

Fig. 7 shows an example in which the device mentioned above is used as a laser diode in an optical communication system. In Fig. 7, a plurality of terminals $68_1$, $68_2$, $\cdots$, $68_n$ are connected to an optical fiber 66 to transmit light signals, through optical nodes 67, $67_2$, $\cdots$, $67_n$. Connected to respective terminals are terminal units $69_1$, $69_2$, $\cdots$, $69_n$ which respectively include a keyboard, a display device and so forth. Each terminal has a light signal transmitter including a modulator circuit 63, a laser light source 62 and a light signal receiver comprising of a photodetector 80 and a demodulator circuit 81. The transmitter and receiver are controlled by a controller 64 in accordance with an instruction from the terminal unit $69_1$. The semiconductor laser device as discussed above can preferably be used as the laser diode source 62. In particular, a frequency division multiplexing optical communication can be attained by using the laser diode source as a tunable laser.

While there has been shown and described what are considered preferred embodiments of the present invention, it will be obvious to those skilled in the art that various changes and modifications may be made therein without departing from the invention as defined by the following claims.

## Claims

1. A semiconductor laser device, comprising:

   a plurality of light emitting quantum well layers (11a, 11b; 21a, 21b; 31a; 31b) having band gaps ($E_{g1}$, $E_{g2}$) of ground energy levels being different from each other;
   a barrier layer (12; 22; 32) formed between said light emitting quantum well layers (11a, 11b; 21a, 21b; 31a, 31b), said barrier layer (12; 22; 32) having a band gap being larger than those of said light emitting quantum well layers (11a, 11b; 21a, 21b; 31a, 31b); and
   a pair of light-electron confinement layers (10a;

10b; 20a, 20b; 35, 30b) for sandwiching said light emitting quantum well layers (11a, 11b; 21a, 21b; 31a, 31b) and said barrier layer (12; 22; 32);

wherein said light emitting quantum well layers (11a, 11b; 21a, 21b; 31a, 31b), said barrier layer (12; 22; 32) and said light-electron confinement layers (10a, 10b; 20a, 20b; 35, 30b) are formed such that, when carriers are injected into said light emitting quantum well layers (11a, 11b; 21a, 21b; 31a, 31b), a carrier density of said light emitting quantum well layer (11b; 21b; 31b) having a larger band gap ($E_{g2}$) is made higher and a carrier density of said light emitting quantum well layer (11a; 21a; 31a) having a smaller band gap ($E_{g1}$) is made lower than those which would be obtained when said barrier layer (12; 22; 32) is omitted, and

wherein said pair of light-electron confinement layers (10a, 10b; 20a, 20b; 35, 30b) are asymmetrically formed with respect to said light emitting quantum well layers (11a, 11b; 21a, 21b; 31a, 31b),

**said semiconductor laser device being characterized in that**

said light-electron confinement layers (10a, 10b; 20a, 20b; 35, 30b) have band gaps being different from each other at the interface where each of said light-electron confinement layers (10a, 10b; 20a, 20b; 35, 30b) is adjacent to the corresponding light emitting quantum well layer (11a, 11b; 21a, 21b; 31a, 31b), with the light-electron confinement layer (10b; 20b; 30b) having the smaller band gap being disposed adjacent to the light emitting quantum well layer (11b; 21b; 31b) having the larger band gap ($E_{g2}$).

2. A semiconductor laser device according to claim 1, **characterized by** a clad layer (3, 5) disposed outside of said light emitting quantum well layers (11a, 11b; 21a, 21b), said barrier layer (12; 22) and said light-electron confinement layers (10a, 10b; 20a; 20b).

3. A semiconductor laser device according to claim 1, **characterized in that** a thickness of said light emitting quantum well layer (11a; 21a; 31a) having a smaller band gap is set to a value less than that which is required for carrier to decrease its energy to a value less than its potential energy at said barrier layer (12; 22; 32) due to its nonelastic scattering.

4. A semiconductor laser device according to claim 2, **characterized in that** the band gap of one of said light-electron confinement layers (20a) is set to a value larger than that of said barrier layer (22) and smaller than that of said clad layer, and the band gap of the other one of said light-electron confinement layers (20b) is set to a value larger than that of said light emitting quantum well layer (21b) having a larger band gap ($E_{g2}$) and smaller than that of said clad layer.

5. A semiconductor laser device according to claim 4, **characterized in that** the band gaps of said light-electron confinement layers (10a, 10b; 20a, 20b) are gradually varied.

6. A semiconductor laser device according to claim 2, **characterized in that** said light-electron confinement layer (35) disposed near said light emitting quantum well layer (31a) having a smaller band gap ($E_{g1}$) comprises said clad layer.

7. A semiconductor laser device according to claim 1, **characterized in that** the band gap of said barrier layer (22) is gradually varied.

8. A semiconductor laser device according to claim 1, **characterized in that** at least one of said barrier layer (12; 22; 32), said light emitting quantum well layers (11a, 11b; 21a, 21b; 31a, 31b) is at least partially doped with one of p-type and n-type dopants.

9. A semiconductor laser device according to claim 8, **characterized in that** said doping is p-type and electrons are injected into said light emitting quantum well layers (11a, 11b; 21a, 21b; 31a, 31b) unevenly.

10. A semiconductor laser device according to claim 8, **characterized in that** said doping is n-type and holes are injected into said light emitting quantum well layers (11a, 11b; 21a, 21b; 31a, 31b) unevenly.

11. A semiconductor laser device according to claim 1, **characterized by** a plurality of electrodes (7a, 7b) for injecting currents ($J_1$, $J_2$) with different current densities in a direction of resonance of said semiconductor laser device.

12. A method for driving a semiconductor laser device according to any of the preceding claims 1 to 11, **said method being characterized by the steps of:**

injecting a current ($J_1$, $J_2$) in a forward direction into said semiconductor laser device;
controlling an amount of said current ($J_1$, $J_2$); and
performing a laser oscillation of light having a wavelength corresponding to any desired one of the band gaps ($E_{g1}$, $E_{g2}$) of said light emitting quantum well layers (11a, 11b; 21a, 21b; 31a, 31b).

13. A method for driving a semiconductor laser device according to any of the preceding claims 1 to 11, **said method being characterized by the steps of:**

injecting a current ($J_1$, $J_2$), having an amount slightly smaller than that of a threshold current for performing a laser oscillation, into said semiconductor laser device; causing an incident light having a wavelength close to that of a laser oscillation light to enter said semiconductor laser device through its one end surface; and

taking out a light having the same wavelength as that of the incident light through the other end surface of said semiconductor laser device.

14. A method for driving a semiconductor laser device according to any of the preceding claims 1 to 11, **said method being characterized by the steps of:**

injecting a current ($J_1$, $J_2$), having an amount slightly smaller than that of a threshold current for performing a laser oscillation, into said semiconductor laser device; causing an incident light having a photon energy larger than a band gap of its light emitting quantum well layer to enter said semiconductor laser device through its one end surface; and taking out a light having a wavelength different from that of the incident light through the other end surface of said semiconductor laser device.

15. An optical communication system including a semiconductor laser device (62) according to any of the preceding claims 1 to 11, **characterized in that** said system comprises a plurality of terminals ($68_1$ to $68_n$), each of said terminals ($68_1$ to $68_n$) including a light transmitter (62, 63) including a semiconductor laser device (62) and a light receiver (80, 81), and an optical fiber (66) for connecting said plurality of terminals ($68_1$ to $68_n$) with each other.

16. An optical communication system according to claim 15, **characterized in that** said light transmitter (62, 63) further includes a modulating circuit (63) connected to said semiconductor laser device (62).

17. An optical communication system according to claim 15, **characterized in that** said light receiver (80, 81) includes a light detector (80) for detecting a light signal, and a demodulating circuit (81) connected to said optical detector (80).

18. An optical communication system according to claim 15, **characterized in that** each of said terminals ($68_1$ to $68_n$) further includes a controller (64) for controlling said light transmitter (62, 63) and said light receiver (80, 81).

19. An optical communication system according to claim 15, **characterized by further comprising** a terminal unit ($69_1$ to $69_n$) connected to each of said terminals ($68_1$ to $68_n$), said terminal unit ($69_1$ to $69_n$) including a keyboard and a display device.

**Patentansprüche**

1. Halbleiterlaser-Vorrichtung, umfassend:

eine Vielzahl von lichtemittierenden Quantentopfschichten (11a, 11b; 21a, 21b; 31a, 31b) mit Bandlücken ($E_{g1}$, $E_{g2}$), deren Energie-Grundniveaus voneinander verschieden sind;

eine Barrierenschicht (12; 22; 32), die zwischen den lichtemittierenden Quantentopfschichten (11a, 11b; 21a, 21b; 31a, 31b) gebildet ist, wobei die Barrierenschicht (12; 22; 32) eine Bandlücke hat, die größer als die der lichtemittierenden Quantentopfschichten (11a, 11b; 21a, 21b; 31a, 31b) ist; und

ein Paar Schichten für den Einschluß von Licht/Elektronen (10a; 10b; 20a, 20b; 35, 30b) zum sandwichartigen Umgeben der lichtemittierenden Quantentopfschichten (11a, 11b; 21a, 21b; 31a, 31b) und der Barrierenschicht (12; 22; 32);

worin die lichtemittierenden Quantentopfschichten (11a, 11b; 21a, 21b; 31a, 31b), die Barrierenschicht (12; 22; 32) und die Schichten für den Einschluß von Licht/Elektronen (10a; 10b; 20a, 20b; 35, 30b) so gebildet sind, daß, wenn Ladungsträger in die lichtemittierenden Quantentopfschichten (11a, 11b; 21a, 21b; 31a, 31b) injiziert werden, die Ladungsträgerdichte der lichtemittierenden Quantentopfschichten (11b; 21b; 31b) mit einer größeren Bandlücke ($E_{g2}$) höher gemacht wird und die Ladungsträgerdichte der lichtemittierenden Quantentopfschichten (11a; 21a; 31a) mit einer kleineren Bandlücke ($E_{g1}$) niedriger gemacht wird als diejenigen, die erhalten würden, wenn die Barrierenschicht (12; 22; 32) weggelassen wird, und

worin das Paar Schichten für den Einschluß von Licht/Elektronen (10a; 10b; 20a, 20b; 35, 30b) in Bezug auf die lichtemittierenden Quantentopfschichten (11a, 11b; 21a, 21b; 31a, 31b) asymmetrisch gebildet sind,

wobei die Halbleiterlaser-Vorrichtung dadurch gekennzeichnet ist, daß

die Schichten für den Einschluß von Licht/Elektronen (10a; 10b; 20a, 20b; 35, 30b) an der Grenzschicht, an der jede der Schichten für den Einschluß von Licht/Elektronen (10a; 10b; 20a, 20b; 35, 30b) an die entsprechende lichtemittierende Quantentopfschicht (11a, 11b; 21a, 21b; 31a, 31b) angrenzt, voneinander verschiedene Bandlücken haben, wobei die Licht-Elektronen-Einschlußschicht (10b; 20b; 30b) mit der kleineren Bandlücke angrenzend an die lichtemittierende Quantentopfschicht (11b; 21b; 31b) mit der größeren Bandlücke ($E_{g2}$) angeordnet ist.

2. Halbleiterlaser-Vorrichtung nach Anspruch 1, dadurch gekennzeichnet, daß eine Mantelschicht (3, 5) außerhalb der lichtemittierenden Quantentopfschichten (11a, 11b; 21a, 21b; 31a, 31b), der Barrierenschicht (12; 22; 32) und den Schichten für den Einschluß von Licht/Elektronen (10a; 10b; 20a, 20b; 35, 30b) angeordnet ist.

3. Halbleiterlaser-Vorrichtung nach Anspruch 1, dadurch gekennzeichnet, daß eine Dicke der lichtemittierenden Quantentopfschicht (11a; 21a; 31a) mit einer kleineren Bandlücke auf einen Wert eingestellt ist, der kleiner ist als eine Länge, die erforderlich ist, damit die Energie eines Ladungsträgers aufgrund seiner nichtelastischen Streuung auf einen Wert abnimmt, der kleiner als seine potentielle Energie bei der Barrierenschicht (12; 22; 32) ist.

4. Halbleiterlaser-Vorrichtung nach Anspruch 2, dadurch gekennzeichnet, daß die Bandlücke von einer der Schichten für den Einschluß von Licht/Elektronen (20a) auf einen Wert eingestellt ist, der größer als der der Barrierenschicht (22) und kleiner als der der Mantelschicht ist, und daß die Bandlücke von der anderen der Schichten für den Einschluß von Licht/Elektronen (20b) auf einen Wert eingestellt ist, der größer als der der lichtemittierenden Quantentopfschicht (21b) mit einer größeren Bandlücke ($E_{g2}$) und kleiner als der der Mantelschicht ist.

5. Halbleiterlaser-Vorrichtung nach Anspruch 4, dadurch gekennzeichnet, daß die Bandlücken der Schichten für den Einschluß von Licht/Elektronen (10a; 10b; 20a, 20b) graduell variiert sind.

6. Halbleiterlaser-Vorrichtung nach Anspruch 2, dadurch gekennzeichnet, daß die Licht-Elektronen-Einschlußschicht (35), die nahe der lichtemittierenden Quantentopfschicht (31a) mit einer kleineren Bandlücke ($E_{g1}$) angeordnet ist, die Mantelschicht umfaßt.

7. Halbleiterlaser-Vorrichtung nach Anspruch 1, dadurch gekennzeichnet, daß die Bandlücke der Barrierenschicht (22) graduell variiert ist.

8. Halbleiterlaser-Vorrichtung nach Anspruch 1, dadurch gekennzeichnet, daß mindestens eine von der Barrierenschicht (12; 22; 32), den lichtemittierenden Quantentopfschichten (11a, 11b; 21a, 21b; 31a, 31b) mindestens teilweise mit Dotiermitteln entweder vom p-Typ oder vom n-Typ dotiert ist.

9. Halbleiterlaser-Vorrichtung nach Anspruch 8, dadurch gekennzeichnet, daß die Dotierung vom p-Typ ist und Elektronen in die lichtemittierenden Quantentopfschichten (11a, 11b; 21a, 21b; 31a, 31b) ungleichmäßig injiziert werden.

10. Halbleiterlaser-Vorrichtung nach Anspruch 8, dadurch gekennzeichnet, daß die Dotierung vom n-Typ ist und Löcher in die lichtemittierenden Quantentopfschichten (11a, 11b; 21a, 21b; 31a, 31b) ungleichmäßig injiziert werden.

11. Halbleiterlaser-Vorrichtung nach Anspruch 1, gekennzeichnet durch eine Vielzahl von Elektroden (7a, 7b) zum Injizieren von Strömen ($J_1$, $J_2$) mit verschiedenen Stromdichten in einer Resonanzrichtung der Halbleiterlaservorrichtung.

12. Verfahren zum Betreiben einer Halbleiterlaser-Vorrichtung nach einem der vorhergehenden Ansprüche 1 bis 11, wobei das Verfahren durch die folgenden Schritte gekennzeichnet ist:

Injizieren eines Stroms ($J_1$, $J_2$) in eine Vorwärtsrichtung in die Halbleiterlaser-Vorrichtung;

Steuern einer Menge des Stroms ($J_1$, $J_2$); und

Durchführen von Laser-Oszillation von Licht mit einer Wellenlänge, die einer erwünschten der Bandlücken ($E_{g1}$, $E_{g2}$) der lichtemittierenden Quantentopfschichten (11a, 11b; 21a, 21b; 31a, 31b) entspricht.

13. Verfahren zum Betreiben einer Halbleiterlaser-Vorrichtung nach einem der vorhergehenden Ansprüche 1 bis 11, wobei das Verfahren durch die folgenden Schritte gekennzeichnet ist:

Injizieren eines Stroms ($J_1$, $J_2$) mit einer Menge, die geringfügig kleiner als die eines Schwellenwert-Stroms zum Durchführen für Laser-Oszillation ist, in die Halbleiterlaser-Vorrichtung;

Eintretenlassen eines einfallenden Lichtstrahls mit einer Wellenlänge nahe bei der von Laseroszillations-Licht in die Halbleiterlaser-Vorrichtung durch ihre eine Endfläche; und

Entnehmen von Licht mit derselben Wellenlänge wie der von dem einfallenden Licht durch die andere Endfläche der Halbleiterlaser-Vorrichtung.

14. Verfahren zum Betreiben einer Halbleiterlaser-Vorrichtung nach einem der vorhergehenden Ansprüche 1 bis 11, wobei das Verfahren durch die folgenden Schritte gekennzeichnet ist:

Injizieren eines Stroms ($J_1$, $J_2$) mit einer Menge, die geringfügig kleiner als die eines Schwellenwertstroms zum Durchführen von Laseroszillation ist, in die Halbleiterlaser-Vorrichtung;

Eintretenlassen eines einfallenden Lichtstrahls mit einer Photonenenergie größer als einer Bandlücke von ihrer lichtemittierenden Quantentopfschicht in die Halbleiterlaser-Vorrichtung durch seine eine Endfläche; und

Entnehmen von Licht mit einer Wellenlänge, die von der des einfallenden Lichts verschieden ist, durch die andere Endfläche der Halbleiterlaser-Vorrichtung.

15. Optisches Kommunikationssystem mit einer Halbleiterlaser-Vorrichtung (62) nach einem der vorhergehenden Ansprüche 1 bis 11, dadurch gekennzeichnet, daß
das System eine Vielzahl von Terminals ($68_1$ bis $68_n$), wobei jedes der Terminals ($68_1$ bis $68_n$) eine Licht-Transmissionsvorrichtung (62, 63) mit einer Halbleiterlaser-Vorrichtung (62) und eine Lichtempfangsvorrichtung (80, 81) enthält, und eine optische Faser (66) zum Verbinden der Vielzahl von Terminals ($68_1$ bis $68_n$) miteinander umfaßt.

16. Optisches Kommunikationssystem nach Anspruch 15, dadurch gekennzeichnet, daß
die Licht-Transmissionsvorrichtung (62, 63) ferner einen Modulationskreis (63) umfaßt, der mit der Halbleiterlaser-Vorrichtung (62) verbunden ist.

17. Optisches Kommunikationssystem nach Anspruch 15, dadurch gekennzeichnet, daß
die Licht-Empfangseinrichtung (80, 81) einen Licht-Detektor (80) zum Nachweisen eines Lichtsignals und einen Demodulationskreis (81), der mit dem optischen Detektor (80) verbunden ist, umfaßt.

18. Optisches Kommunikationssystem nach Anspruch 15, dadurch gekennzeichnet, daß jedes der Terminals ($68_1$ bis $68_n$) ferner eine Steuereinrichtung (64) zum Steuern der Licht-Transmissionseinrichtung (62, 63) und der Licht-Empfangseinrichtung (80, 81) umfaßt.

19. Optisches Kommunikationssystem nach Anspruch 15, dadurch gekennzeichnet, daß es ferner eine Terminaleinheit ($69_1$ bis $69_n$) umfaßt, die mit jedem der Terminals ($68_1$ bis $68_n$) verbunden ist, wobei die Terminaleinheit ($69_1$ bis $69_n$) eine Tastatur und eine Anzeigevorrichtung umfaßt.

## Revendications

1. Dispositif à laser à semiconducteur comprenant:

une pluralité de couches (11a, 11b; 21a, 21b; 31a; 31b) à puits quantiques, émettrices de lumière, comportant des bandes interdites ($E_{g1}$, $E_{g2}$) dont les niveaux d'énergie de masse sont différents les uns des autres;
une couche d'arrêt (12; 22; 32) formée entre lesdites couches (11a, 11b; 21a, 21b; 31a, 31b) à puits quantiques, émettrices de lumière, ladite couche d'arrêt (12; 22; 32) ayant une bande interdite supérieure à celles desdites couches (11a, 11b; 21a, 21b; 31a, 31b) à puits quantiques, émettrices de lumière; et
une paire de couches (10a; 10b; 20a, 20b; 35, 30b) de confinement lumière-électrons destinées à prendre en sandwich lesdites couches (11a, 11b; 21a, 21b; 31a, 31b) à puits quantiques, émettrices de lumière, et ladite couche d'arrêt (12; 22; 32);
dans lequel lesdites couches (11a, 11b; 21a, 21b; 31a, 31b) à puits quantiques, émettrices de lumière, ladite couche d'arrêt (12; 22; 32) et lesdites couches (10a, 10b; 20a, 20b; 35, 30b) de confinement lumière-électrons sont formées de telle sorte que, lorsque les porteurs sont injectés dans lesdites couches 111a, 11b; 21a, 21b; 31a, 31b) à puits quantiques, émettrices de lumière, la densité de porteurs de ladite couche (11b; 21b; 31b) à puits quantiques émettrice de lumière, ayant une bande interdite ($E_{g2}$) plus large, est augmentée, et la densité de porteurs de ladite couche (11a; 21a; 31a) à puits quantiques émettrice de lumière ayant une bande interdite ($E_{g1}$) plus étroite, est réduite par rapport à celles qui seraient obtenues si ladite couche d'arrêt (12; 22; 32) était supprimée, et
dans lequel les couches (10a, 10b; 20a, 20b; 35, 30b) de ladite paire de couches de confinement lumière-électrons sont formées de manière asymétrique par rapport auxdites couches (11a, 11b; 21a, 21b; 31a, 31b) à puits quantiques, émettrices de lumière,
**ledit dispositif à laser à semiconducteur**

**étant caractérisé en ce que**

lesdites couches (10a, 10b; 20a, 20b; 35, 30b) de confinement lumière-électrons ont des bandes interdites différentes les unes des autres à l'interface où chacune desdites couches (10a, 10b; 20a, 20b; 35, 30b) de confinement lumière-électrons est adjacente à la couche correspondante (11a, 11b; 21a, 21b; 31a, 31b) à puits quantiques, émettrice de lumière, la couche (10b; 20b; 30b) de confinement lumière-électrons ayant la bande interdite plus étroite étant disposée dans une position adjacente à la couche (11b; 21b; 31b) à puits quantiques émettrice de lumière ayant la bande interdite plus large ($E_{g2}$).

2. Dispositif à laser à semiconducteur selon la revendication 1,

**caractérisé par** une couche de recouvrement (3, 5) disposée à l'extérieur desdites couches (11a, 11b; 21a, 21b) à puits quantiques, émettrices de lumière, de ladite couche d'arrêt (12; 22) et desdites couches (10a, 10b; 20a, 20b) de confinement lumière-électrons.

3. Dispositif à laser à semiconducteur selon la revendication 1,

**caractérisé en ce que** l'épaisseur de ladite couche (11a; 21a; 31a) à puits quantiques, émettrice de lumière ayant une bande interdite plus étroite, est établie à une valeur inférieure à celle qui est nécessaire pour que l'énergie du porteur diminue à une valeur inférieure à son énergie potentielle au niveau de ladite couche (12; 22; 32) d'arrêt sous l'effet de sa dispersion non élastique.

4. Dispositif à laser à semiconducteur selon la revendication 2,

**caractérisé en ce que** la bande interdite de l'une desdites couches (20a) de confinement lumière-électrons est établie à une valeur supérieure à celle de ladite couche (22) d'arrêt et inférieure à celle de ladite couche de recouvrement, et la bande interdite de l'autre desdites couches (20b) de confinement lumière-électrons est établie à une valeur supérieure à celle de la couche (21b) à puits quantiques, émettrice de lumière ayant une bande interdite ($E_{g2}$) plus large, et inférieure à celle de ladite couche de recouvrement.

5. Dispositif à laser à semiconducteur selon la revendication 4,

**caractérisé en ce que** lesdites bandes interdites desdites couches (10a, 10b; 20a, 20b) de confinement lumière-électrons varient de manière graduelle.

6. Dispositif à laser à semiconducteur selon la revendication 2,

**caractérisé en ce que** ladite couche (35) de confinement lumière-électrons, disposée à proximité de ladite couche (31a) à puits quantiques, émettrice de lumière ayant une bande interdite plus étroite ($E_{g1}$), comprend ladite couche de recouvrement.

7. Dispositif à laser à semiconducteur selon la revendication 1,

**caractérisé en ce que** la bande interdite de ladite couche (22) d'arrêt varie de manière graduelle.

8. Dispositif à laser à semiconducteur selon la revendication 1,

**caractérisé en ce qu'**au moins l'une de ladite couche (12; 22; 32) d'arrêt desdites couches (11a, 11b; 21a, 21b; 31a, 31b) à puits quantiques, émettrices de lumière, est au moins partiellement dopée avec l'un de dopants de type p et de type n.

9. Dispositif à laser à semiconducteur selon la revendication 8,

**caractérisé en ce que** ledit dopage est de type p et des électrons sont injectés de manière non uniforme dans lesdites couches (11a, 11b; 21a, 21b; 31a, 31b) à puits quantiques, émettrices de lumière.

10. Dispositif à laser à semiconducteur selon la revendication 8,

**caractérisé en ce que** ledit dopage est de type n et des trous sont injectés de manière non uniforme dans lesdites couches (11a, 11b; 21a, 21b; 31a, 31b) à puits quantiques, émettrices de lumière.

11. Dispositif à laser à semiconducteur selon la revendication 1,

**caractérisé par** une pluralité d'électrodes (7a, 7b) pour injecter des courants ($J_1$, $J_2$) avec différentes densités de courant dans la direction de résonance dudit dispositif à laser à semiconducteur.

12. Procédé de commande d'un dispositif à laser à semiconducteur selon l'une quelconque des revendications précédentes 1 à 11,

**ledit procédé étant caractérisé par les étapes suivantes**:

injection d'un courant ($J_1$, $J_2$) dans le sens direct, dans ledit dispositif à laser à semiconducteur;

commande d'une valeur dudit courant ($J_1$, $J_2$; et réalisation d'une oscillation laser de la lumière ayant une longueur d'onde correspondant à une certaine bande interdite souhaitée parmi les bandes interdites ($E_{g1}$, $E_{g2}$) desdites couches (11a, 11b; 21a, 21b; 31a, 31b) à puits quantiques, émettrices de lumière.

13. Procédé de commande d'un dispositif à laser à semiconducteur selon l'une quelconque des revendications précédentes 1 à 11,

**ledit procédé étant caractérisé par les étapes suivantes:**
injection d'un courant ($J_1$, $J_2$), ayant une valeur légèrement inférieure à celle d'un courant de seuil pour réaliser une oscillation laser dans ledit dispositif à laser à semiconducteur;
entrée d'une lumière incidente ayant une longueur d'onde proche de celle d'une lumière à oscillation laser, que l'on fait pénétrer dans ledit dispositif à laser à semiconducteur à travers sa surface d'extrémité; et
sortie d'une lumière ayant la même longueur d'onde que celle de la lumière incidente que l'on a fait passer à travers l'autre surface d'extrémité dudit dispositif à laser à semiconducteur.

14. Procédé de commande d'un dispositif à laser à semiconducteur selon l'une quelconque des revendications précédentes 1 à 11,

**ledit procédé étant caractérisé par les étapes suivantes:**
injection d'un courant ($J_1$, $J_2$), ayant une valeur légèrement inférieure à celle d'un courant de seuil pour réaliser une oscillation laser, dans ledit dispositif à laser à semiconducteur;
entrée d'une lumière incidente ayant une énergie de photons supérieure à la bande interdite de sa couche à puits quantiques, émettrice de lumière, que l'on a fait pénétrer dans ledit dispositif à laser à semiconducteur à travers sa première surface d'extrémité; et
sortie d'une lumière ayant une longueur d'onde différente de celle de la lumière incidente que l'on fait passer à travers l'autre surface d'extrémité dudit dispositif à laser à semiconducteur.

15. Système de communication optique comportant un dispositif (62) à laser à semiconducteur selon l'une quelconque des revendications précédentes 1 à 11,

**caractérisé en ce que**
ledit système comprend une pluralité de bornes ($68_1$ à $68_n$), chacune desdites bornes ($68_1$ à $68_n$) comportant un émetteur (62, 63) de lumière comportant un dispositif (62) à laser à semiconducteur et un récepteur (80, 81) de lumière, et une fibre optique (66) pour relier ladite pluralité de bornes ($68_1$ à $68_n$) les unes avec les autres.

16. Système de communication optique selon la revendication 15,

**caractérisé en ce que**
ledit émetteur (62, 63) de lumière comporte en outre un circuit (63) de modulation connecté audit dispositif (62) à laser à semiconducteur.

17. Système de communication optique selon la revendication 15,

**caractérisé en ce que**
ledit récepteur (80, 81) de lumière comporte un détecteur (80) de lumière pour détecter un signal lumineux, et un circuit (81) de démodulation connecté audit détecteur optique (80).

18. Système de communication optique selon la revendication 15,

**caractérisé en ce que**
chacune desdites bornes ($68_1$ à $68_n$) comporte en outre un dispositif de commande (64) pour commander ledit émetteur (62, 63) de lumière et ledit récepteur (80, 81) de lumière.

19. Système de communication optique selon la revendication 15,

**caractérisé en ce qu'il comprend en outre**
une unité formant terminal ($69_1$ à $69_n$) connectée à chacune desdites bornes ($68_1$ à $68_n$), ladite unité formant terminal ($69_1$ à $69_n$) comportant un clavier et un dispositif d'affichage.

# FIG.IA

101

CONDUCTION
BAND

$\lambda_2 \leftarrow Eg_{12}$   $Eg_{11} \rightarrow \lambda_1$

VALENCE
BAND

# FIG.IB

GAIN

gth'

gtho

$\lambda_2$          $\lambda_1$          $\lambda$

14

# FIG . 2A

FIG. 2B

FIG. 2C

FIG. 2D

EP 0 491 152 B1

FIG. 3A

LIGHT
WAVEGUIDE

FIG. 3B

# FIG. 4

# FIG. 5

Eg₁     Eg₂

p

n

20a   21a   22   21b   20b

# FIG.6

# FIG.7

EP 0 491 152 B1